Europäisches Patentamt

European Patent Office

Office européen des brevets

(19)

(11) Veröffentlichungsnummer: **0 102 489**
**B1**

(12) # EUROPÄISCHE PATENTSCHRIFT

(45) Veröffentlichungstag der Patentschrift:
04.02.87

(51) Int. Cl.⁴: **H 01 L 39/12, H 01 L 39/24**

(21) Anmeldenummer: **83106945.5**

(22) Anmeldetag: **15.07.83**

(54) Supraleitendes Faserbündel und Verfahren zu dessen Herstellung.

(30) Priorität: **31.07.82 DE 3228729**
**06.10.82 DE 3236896**

(43) Veröffentlichungstag der Anmeldung:
**14.03.84 Patentblatt 84/11**

(45) Bekanntmachung des Hinweises auf die Patenterteilung:
**04.02.87 Patentblatt 87/6**

(84) Benannte Vertragsstaaten:
**CH DE FR GB IT LI NL**

(56) Entgegenhaltungen:
**FR-A-2 136 868**
**FR-A-2 285 724**
**FR-A-2 445 595**

**IEEE TRANSACTIONS ON MAGNETICS, Band MAG-17, Nr. 1, Januar 1981, Seiten 573-576, IEEE, New York, USA; J.R. GAVALER et al.: "Dimensional effects on current and field properties in NbN films"**
**REVUE GENERALE DE L'ELECTRICITE, Band 88, Nr. 2, 1979, Seiten 105-113, Paris, FR; J. MAZUER et al.: "1 - Les carbonitrures de niobium supraconducteurs"**
**EXTENDED ABSTRACTS, Band 79-2, 14.-19. Oktober 1979, Seiten 1061-1062, The Electrochemical Society, Fall meeting, Princeton, New Jersey, USA; K. BRENNFLECK et al.: "Chemical vapor deposition of**

(73) Patentinhaber: **BROWN, BOVERI & CIE Aktiengesellschaft, Kallstadter Strasse 1, D-6800 Mannheim 31 (DE)**
Patentinhaber: **Kernforschungszentrum Karlsruhe GmbH, Weberstrasse 5 Postfach 3640, D-7500 Karlsruhe 1 (DE)**

(72) Erfinder: **Dietrich, Manfred, Dr., Dipl.- Phys., Trierer Strasse 33, D-7500 Karlsruhe (DE)**
Erfinder: **Dustmann, Cord- Heinrich, Dr., Dipl.- Phys., Diemstrasse 10, D-6940 Weinheim (DE)**
Erfinder: **Schmaderer, Franz, Dipl.- Ing., Türmergasse 13, D-6900 Heidelberg (DE)**
Erfinder: **Wahl, Georg Friedrich Hermann, Dr., Dipl.- Phys., Franz- Liszt- Strasse 8, D-6901 Eppelheim (DE)**

(74) Vertreter: **Kempe, Wolfgang, Dr., c/o Brown, Boveri & Cie AG Postfach 351, D-6800 Mannheim 1 (DE)**

(56) Entgegenhaltungen: (Fortsetzung)
**superconducting niobium carbonitride films on carbon fibres"**

EP 0 102 489 B1

## Beschreibung

Die Erfindung betrifft ein supraleitendes Faserbündel, das aus einer Vielzahl mit einer supraleitenden Schicht aus einer Niobverbindung der allgemeinen Formel $NbC_xN_yO_z$ ($x+y+z$ kleiner/gleich 1) beschichteten Trägerfasern, wie z.B. Kohlenstoffasern, Borfasern, Stahlfasern besteht.

Bei der Weiterentwicklung der Energietechnik im Hinblick auf die Kernfusion und auf supraleitende Generatoren, der Verkehrstechnik (Magnetschwebebahn), der Umwelttechnik (Kohlenentschwefelung) und der Hochenergiephysik werden Starkfeldmagnete benötigt, die unter wirtschaftlichen Gesichtspunkten nur auf Supraleiterbasis hergestellt werden können.

Ein neues aussichtsreiches Supraleitungsmaterial ist z.B. $NbC_xN_yO_z$ ($x+y+z$ kleiner/gleich 1), welches auf Trägerfasern eines Faserbündels (Anzahl der Fasern beliebig) aufgebracht als Faserleiter angewandt werden kann. Nioboxycarbonitrid sowie insbesondere Niobcarbonitrid, bei dem $z=0$ ist, zeichnen sich durch hohe kritische Temperaturen, hohe kritische Magnetfelder und hohe kritische Stromdichten aus. Als Trägerfasermaterial kann jeder geeignete Werkstoff verwandt werden (z.B. C, B, Stahl), der die erforderliche mechanische Festigkeit aufweist. Er dient als zugfeste Matrix und als Substrat für ein chemisches Gasphasenabscheideverfahren (CVD = chemical vapor deposition), bei dem das Niob durch Reaktion von $NbCl_5$ mit $H_2$ in Gegenwart von kohlenstoff- und stickstoffhaltigen Gasen als dünner Film abgeschieden wird. Der CVD-Prozeß wird dabei entweder einstufig (gleichzeitige Nb-Abscheidung und Carbonitrierung) oder zweistufig (Nb-Abscheidund und Carbonitrierung zeitlich aufeinander folgend) durchgeführt.

Durch die DE-AS 28 56 885 ist ein zweistufiges CVD-Verfahren bekannt geworden, das bei Gasdrücken größer bzw. gleich Normaldruck durchgeführt wird. Die mit diesem Verfahren herstellbaren Schichten sind prinzipiell noch zu grobkörnig, um bestmögliche Supraleitereigenschaften zu erreichen. Die erreichbaren Korngrößen der Niobcarbonitridkristalle liegen bei 50 bis 100 nm.

Supraleitende Parameter, wie die obere kritische magnetische Feldstärke $H_{C2}$, sind neben den üblichen Einflüssen wie Zusammensetzung, Ordnungsgrad, Reinheit u.ä. insbesondere auch vom metallurgischen Korngefüge abhängig. Aus einer Korngrößenreduktion folgt wegen der damit verbundenen Verminderung der freien Weglänge der Leitungselektronen eine Zunahme des Ginsburg-Landau-Parameters $k$ ($k$ = Kohärenzlänge/magnetische Eindringtiefe), und, da $H_{C2}$ proportional zu $k \cdot H_C$ ($H_C$: thermodynamische kritische Magnetfeldstärke) ist, eine Zunahme des magnetischen Feldes $H_{C2}$ sofern das thermodynamische kritische Feld $H_C$ bei dieser Kornverkleinerung nicht in demselben Maße abnimmt. Bei Nioboxycarbonitrid reagieren die thermodynamischen Eigenschaften, insbesondere das thermodynamische kritische Feld $H_C$ wegen ihrer ohnehin kleinen freien Weglänge der Leitungselektronen nicht empfindlich auf eine weitere Verkleinerung als Folge einer Korngrößenreduktion, so daß bei dieser Substanz (wie auch bei anderen B1-Struktur-Supraleitern) aus einer Korngrößenreduktion eine Zunahme des Magnetfeldes $H_{C2}$ folgt.

Mittels Kathodenzerstäubung (sputtern), durch das dünne Nioboxycarbonitridfilme auf ebenen Trägern aufgebracht wurden, konnte diese Erhöhung der kritischen Magnetfeldstärke $H_{C2}$ infolge Korngrößenreduktion nachgewiesen werden (J.R. Gavaler et al, IEEE Transactions on Magnetics, Volume MAG-17, No. 1, January 1981, Seiten 573 bis 576). Jedoch war bisher die Beschichtung von Fasern eines Trägerfaserbündels mit supraleitendem Nioboxycarbonitrid mit Korngrößen unter 50 nm nicht möglich. Wie erwähnt wurde, konnten durch CVD-Verfahren bisher nur Schichten, deren Korngröße über 50 nm liegt, hergestellt werden. Das Kathodenzerstäubungsverfahren hingegen weist eine Vorzugsrichtung auf, so daß sich das Problem der gegenseitigen Abschattung der einzelnen Fasern des Trägerfaserbündels stellt. Durch das mangelhafte Streuvermögen war eine gleichmäßige Beschichtung der einzelnen Fasern bisher nicht möglich. Ebene Supraleiter sind jedoch technisch nur sehr bedingt einsetzbar, weil die in den Bändern durch Querkomponenten des magnetischen Feldes erzeugten Wirbelströme niemals abklingen und dadurch im Bandleiter zu elektrischen Instabilitäten beitragen.

Im übrigen ist eine Korngrößenreduktion auch im Hinblick auf eine Steigerung der kritischen Stromdichte $J_C$ wünschenswert, da die Korngrenzen sehr wirksame Haftzentren für die magnetischen Flußlinien bilden.

Aufgabe der Erfindung ist es, supraleitende Faserbündel der eingangs genannten Art sowie Verfahren zu deren Herstellung anzugeben, durch die eine homogene, allseitige Beschichtung der einzelnen Fasern des Faserbündels erreicht wird, wobei die supraleitende Schicht hohe Werte für das kritische Magnetfeld und die kritische Stromdichte aufweisen soll.

Diese Aufgabe wird erfindungsgemäß dadurch gelöst, daß das supraleitende Material der supraleitenden Schicht aus feinkörnigem B1-Struktur-Nioboxycarbonitrid oder -Niobcarbonitrid, besteht, dessen mittlere Korngröße zwischen 3 und 50 nm liegt.

Derartige Faserbündel waren bisher weder herstellbar noch bekannt. Eine Mikrostruktur des Nioboxycarbonitrid in B1-Struktur (Kochsalzstruktur) mit einer mittleren Korngröße zwischen 3 und 50 nm ist wegen der damit verbundenen kleinen freien Weglänge und, wie beschrieben wurde, der daraus resultierenden hohen kritischen Magnetfeldstärke $H_{C2}$ besonders vorteilhaft.

Nioboxycarbonitrid, das eine über 50 nm liegende mittlere Korngröße hat, erfüllt die Anforderung zur Herstellung sehr hoher Magnetfelder nicht, da die kritische Magnetfeldstärke $H_{C2}$ sowie die kritische Stromdichte $J_C$ nicht ausreichen. Bei Kristallgefügestrukturen hingegen, deren mittlere Korngröße unter 3 nm liegt, ist eine Röntgenstrukturanalyse wegen deren begrenzten Auflösungsvermögen nicht mehr möglich. Darüberhinaus verschwinden mit abnehmender Korngröße die kristallinen und damit auch die supraleitenden Eigenschaften. Eine vorteilhafte, typische mittlere Korngröße für supraleitende Schichten von Faserbündeln

kann beispielsweise bei 10 nm liegen.

Vorzugsweise liegt die Schichtdicke der supraleitenden Schicht zwischen 100 und 2000 nm. Derartige Schichtdicken sind mit den infolgenden beschriebenen Verfahren herstellbar und gewährleisten die notwendige Stromtragfähigkeit des Faserbündels. Es hat sich gezeigt, daß die Elastizität dünner, feinkörniger Schichten höher ist, als die dickerer und grobkörniger Schichten.

Ferner ist die supraleitende Schicht vorzugsweise mit einer hochleitfähigen Metallschicht, beispielsweise aus hochreinem Kupfer oder Aluminium, die bei eventuellem Ausfall der supraleitenden Eigenschaften den Strom aufzunehmen vermag (Stabilisierung), überzogen.

Eine Erhöhung der Stromtragfähigkeit kann durch Einbau von Pinningzentren erreicht werden. Dies sind Inhomogenitäten im supraleitenden Werkstoff in der Größenordnung der Kohärenzlänge von etwa 5 nm, die sich in den elektrischen Eigenschaften wesentlich vom supraleitenden Werkstoff unterscheiden. Korngrenzen sind derartige geeignete Pinningzentren, so daß sich die beschriebene Reduzierung der Korngröße vorteilhaft auf die Stromtragfähigkeit auswirkt. Dies trifft jedenfalls solange zu, solange der $H_{C2}$-Wert und damit der spezifische elektrische Widerstand der supraleitenden Körner gering ist, so daß die elektrische Leitfähigkeit innerhalb der Körner groß gegenüber der Leitfähigkeit der Korngrenzen ist. Bei den derzeit erreichten $H_{C2}$-Werten ist dieser Unterschied der Leitfähigkeit nicht mehr gewährleistet, da die mittleren freien Weglängen der Elektronen auch im Korn einen so kleinen Wert erreicht haben, daß die genannte Bedingung (Kornleitfähigkeit groß gegen Leitfähigkeit der Korngrenze) nicht mehr erfüllt ist. Es werden daher verschiedene erfindungsgemäße Strukturen der supraleitenden Schicht vorgeschlagen, die eine Erhöhung der Unterschiede der Leitfähigkeit im Korn und an der Korngrenze zeigen:

1.

Zur Herabsetzung der Leitfähigkeit der Korngrenzen ist es zweckmäßig, die supraleitende Schicht derart auszubilden, daß zwischen den B1-Struktur-Nioboxycarboni-trid-Körnern gleichmäßig verteilt Einlagerungen aus isolierendem Material enthalten sind. Diese Einlagerungen wirken als Pinningzentren (Pinning-Körner). Die Größe der Pinning-Körner liegt in der Größenordnung der Kohärenzlänge von ca. 5 nm. Ihre Konzentration kann 50 % der supraleitenden Schicht ausmachen. Als isolierendes Material kommen beispielsweise Oxide wie $ZrO_2$, $TiO_2$, $NbO_2$ oder Carbide wie SiC, NbC oder Nitride wie TiN in Frage.

2.

Ein besonders deutlicher Unterschied der Leitfähigkeit zwischen Korn und Korngrenze ist gemäß einer vorteilhaften Ausgestaltung der Erfindung dann gegeben, wenn in der supraleitenden Schicht Einlagerung aus isolierendem Material an allen Korngrenzflächen der supraleitenden Körner unabhängig von der räumlichen Ausrichtung der Korngrenzflächen abgeschieden sind. Eine derartige Haut aus isolierendem Material an den Korngrenzflächen der supraleitenden Körner hat z.B. eine Schichtdicke von 2 bis 5 nm. Sie ist pinningwirksam, da der normalleitende Kern der Flußschläuche sich gut an dem isolierenden Material verankern kann.

3.

Ferner ist es vorteilhaft, Einlagerungen aus isolierendem Material lediglich an den Korngrenzen der supraleitenden Körner abzuscheiden, die parallel zur Oberfläche der jeweiligen Trägerfaser liegen. Hierbei handelt es sich um einen Vielschichtaufbau (Multilayer) der supraleitenden Schicht, bei der sich supraleitendes Material und isolierendes Material abwechseln. Wenn auch der Pinningeffekt bei einer derartigen Schichtung von der Ausrichtung des Magnetfeldes zu den Schichtungen abhängt, so zeigt sich doch, daß durch die Herstellung einer derartigen Schichtung eine vorteilhafte Kornverfeinerung der supraleitenden Körner erreicht werden kann, da das Wachstum der supraleitenden Körner jeweils bei Abscheidung der isolierenden Schicht unterbrochen wird. Die supraleitenden und isolierenden Schichten können parallel zur Oberfläche der jeweiligen Trägerfaser liegen. Material und Schichtdicke entsprechen den unter Punkt 1. und 2. beschriebenen Strukturbeispielen.

4.

Eine weitere vorteilhafte Modifikation der supraleitenden Schicht ist dadurch gegeben, daß das supraleitende Material neben dem Nioboxycarbonitrid ein weiteres Element enhält, welches die elektrische Leitfähigkeit der supraleitenden Körner erhöht, ohne daß der $H_{C2}$-Wert wesentlich geändert wird. Auch hierdurch wird der Unterschied der elektrischen Leitfähigkeit zwischen Korn und Korngrenzen erhöht. Als Legierungsmaterial kommt beispielsweise Tantal Ta oder Titan Ti infrage.

Besonders vorteilhaft sind supraleitende Schichten, bei denen neben der Verringerung der elektrischen Leitfähigkeit der Korngrenzen durch Einlagerungen aus isolierendem Material, die Leitfähigkeit der supraleitenden Körner durch Zugabe von geeigneten Elementen erhöht ist, so daß sich große Unterschiede der Leitfähigkeit zwischen Korn und Korngrenze ergeben.

Ein Verfahren zur Herstellung erfindungsgemäßer supraleitender Faserbündel ist bisher nicht bekannt geworden. Die bekannten CVD-Verfahren (z.B. DE-AS 28 56 885) ermöglichen zwar eine homogene Beschichtung ganzer Faserbündeln, allerdings liegen die erreichbaren Korngrößen der Niobcarbonitridkristalle lediglich bei 50 bis 100 nm und die supraleitenden Schichtdicken sind in der Regel mit Werten von weniger als 100 nm zu dünn, um eine ausreichende Stromtragfähigkeit zu gewährleisten.

Durch bekannte physikalische Verfahren, wie die reaktive Kathodenzerstäubung (sputtern), gelingt es zwar ein extrem feines Mikrogefüge herzustellen, diese Verfahren weisen jedoch eine Vorzugsrichtung für die Beschichtung auf, d.h. man erreicht die Rückseite eines Substrates nur noch unbefriedigend, so daß nur Schichten auf ebenen Unterlagen aufgebracht werden können. Es war bisher nicht möglich, Faserbündel mit beispielsweise 1000 Einzelfasern homogen zu beschichten, weil die innen liegenden Fasern des Bündels durch die außen liegenden Fasern abgeschattet werden.

Zur Herstellung erfinderischer supraleitender Faserbündel kann von einem Verfahren, bei dem in einem CVD-Reaktor das Nioboxycarbonitrid, insbesondere das Niobcarbonitrid, mit Hilfe der chemischen Abscheidung aus der Gasphase durch Reaktion von Niobchlorid, Kohlenstoff- und Stickstoffverbindungen auf der Trägerfaser abgeschieden wird, ausgegangen werden. Hierbei ist die Zugrundelegung verschiedener bekannter Verfahren möglich. Es kann beispielsweise sowohl von einem einstufigen als auch von einem zweistufigen CVD-Prozeß (DE-AS 28 56 885) ausgegangen werden. Diese Verfahren weisen den Vorteil auf, eine homogene Beschichtung ganzer Faserbündeln zu ermöglichen. Erfindungsgemäß erfolgt die Abscheidung aus der Gasphase unter Einsatz von Plasmaaktivierung und/oder unter Einwirkung eines Ultraschallfeldes, das im CVD-Reaktor durch eine eingefügte, das Gas in Schwingungen versetzende Ultraschallquelle erzeugt werden kann. Überraschenderweise führen bei CVD-Prozessen sowohl die Plasmaaktivierung als auch die Einwirkung von Ultraschallfeldern insbesondere bei der Herstellung von Nioboxycarbonitridschichten unter Verwendung eines CVD-Prozesses zu einer erheblichen Reduktion der Korngrößen, was offenbar auf Störungen der Wachstumsprozesse und erhöhte Keimbildung zurückgeführt werden kann.

J.R. Hollahan und A.T. Bell haben in "Techniques and Application of Plasma Chemistry", New York, 1974 die Anwendung von Plasmen in der Chemie (Plasmaaktivierung oder Gasplatierung) und unter anderem die Wirkung von Plasmen bei CVD-Prozessen beschrieben. Das Ziel der erläuterten Verfahren war es, CVD-Prozesse durch Plasmaaktivierung zu ermöglichen, bzw. die Prozeßtemperatur zu erniedrigen. Ein Hinweis auf eine Korngrößenreduktion durch Plasmaaktivierung oder gar eine Anregung für die Nutzbarmachung einer derartigen Korngrößenreduktion bei der Herstellung von supraleitenden Schichten fehlt jedoch. Es hat sich überdies herausgestellt, daß bei dem erfinderischen Verfahren insbesondere durch Plasmaaktivierung die Abscheidegeschwindigkeit sich um ein Mehrfaches steigern läßt.

Am Beispiel der Titandiborid-Abscheidung aus $TiCl_4$ und $BCl_3$ wurde durch T. Takahashi, H. Itoh, Journal of Crystal Growth 49 (1980) Seite 445 bis 450 festgestellt, daß durch Ultraschalleinwirkung beim CVD-Prozeß die Feinkörnigkeit des Titandiborid erhöht wird. Dort wurde das Substrat auf einen Vibrator aufgebracht und in Schwingungen versetzt. Ziel der Untersuchungen war die Erhöhung der Oberflächenhärte bei mit Titandiborid beschichteten Stahlwerkzeugen. Die Anwendung dieses relativ neuen Verfahrens auf die Herstellung von Supraleitern, insbesondere von supraleitenden Faserbündeln, die nicht an einem Vibrator befestigbar sind, wurde durch diese Veröffentlichung wegen der sehr unterschiedlichen Zielsetzung nicht bekannt.

Das CVD-Verfahren gemäß DE-AS 28 56 885 wird bei Drücken durchgeführt, die größer bzw. gleich Normaldruck sind, um das Eindringen von Kontaminationen in die Abscheideapparatur zu vermeiden. Es hat sich jedoch herausgestellt, daß die Verwendung von Unterdruck wesentliche Vorteile bietet. So kann bei Unterdruck die Beschichtbarkeit komplizierter Körper, also auch die Beschichtbarkeit von Fasern, erhöht werden, so daß insbesondere bei sehr filamentreichen Faserbündeln sehr gute Beschichtungserfolge erzielt werden. Als vorteilhaft haben sich Gesamtgasdrücke zwischen 0,1 und 1000 mbar herausgestellt. Fehlen bei der Beschichtungsanlage jegliche Schleusen nach außen, so kann das Einströmen von Verunreinigungen aus der Außenluft vermieden werden.

Sofern die Nioboxycarbonitridabscheidung bei Anwesenheit eines Plasmas durchgeführt wird (Plasmaaktivierung), wird vorzugsweise ein Gesamtdruck zwischen 0,1 und 5 mbar eingestellt, da bei Niederdruck Plasmen leichter zu zünden sind.

Um verschiedene Einlagerungen aus isolierendem Material in die supraleitende Schicht einzubringen, läßt sich das beschriebene CVD-Verfahren modifizieren. So ist es zur Herstellung von Einlagerungen gemäß der unter Punkt 1 und 2 beschriebenen Strukturen vorteilhaft, wenn in dem CVD-Reaktor simultan zur Nioboxycarbonitrid-Abscheidung das isolierende Material aus der Gasphase abgeschieden wird. Durch Einstellen der Verfahrensparameter, wie Partialdrücke, Temperatur, Beschichtungsdauer, lassen sich sowohl die Korngröße der supraleitenden Körner als auch die Dicke der isolierenden Einlagerungen einstellen.

Für die Herstellung eines schichtweisen Aufbaues der supraleitenden Schicht, bei der sich supraleitende und isolierende Schichten abwechseln (siehe Struktur gemäß Punkt 3), kann die Abscheidung des isolierenden Materials ebenfalls in dem CVD-Reaktor für die Nioboxycarbonitrid-Abscheidung erfolgen. Das isolierende Material kann dabei abwechselnd mit dem Nioboxycarbonitrid aus der Gasphase abgeschieden werden, so daß das Substrat (Trägerfaser) zwiebelschalenartig durch sich abwechselnde supraleitende und isolierende Schichten abgedeckt ist.

Anstelle dieser alternierenden Abscheidung kann zur Herstellung eines Vielschichtaufbaues auch derart verfahren werden, daß während einer kontinuierlichen CVD-Abscheidung von Nioboxycarbonitrid pulsierend, d.h. mit zeitlichen Unterbrechungen, isolierendes Material aus der Gasphase auf das Substrat abgeschieden werden.

Für eine Erhöhung der elektrischen Leitfähigkeit können die supraleitenden Körner aus B1-Struktur-Nioboxycarbonitrid neben Niob, Kohlenstoff, Stickstoff, Sauerstoff, ein weiteres, die Leitfähigkeit steigerndes Element wie Tantal oder Titan enthalten. Um eine derartige Legierung herzustellen, kann eines der beschriebene CVD-Verfahren in der Weise modifiziert werden, daß in dem CVD-Reaktor simultan zur Nioboxycarbontrid-Abscheidung das die Leitfähigkeit erhöhende Element aus der Gasphase abgeschieden wird.

Für die Faserbeschichtung bei der Herstellung erfinderischer supraleitender Faserbündel können trotz eingangs genannter Probleme durch erfinderische Ausgestaltungen auch physikalische Aufdampfverfahren (z.B. Sputter-Prozesse, reaktive Sputter-Prozesse, Ion-plating) zugrundegelegt werden. Derartige Verfahren sind z.B. in K.L.Chopra, "Thin Film phenomena", New York, 1969, beschrieben. Ein weiteres erfinderisches Herstellungsverfahren sieht vor, daß ein Trägerfaserbündel zu einem Trägerfaserband aufgefächert wird, und daß sich eine allseitige Beschichtung des Trägerfaserbandes mit Nioboxycarbonitrid durch Kathodenzerstäubung, insbesondere reaktive Kathodenzerstäubung, von Niob bei gleichzeitiger Anwesenheit von Stickstoff oder einer Stickstoffverbindung und Kohlenstoff oder einer Kohlenstoffverbindung anschließt, wobei das Trägerfaserband gegebenenfalls derart temperiert wird, daß sich das Nioboxycarbonitrid in polykristalliner Form abscheidet.

Einige der zahlreichen Modifikationen des Kathodenzerstäubungsverfahrens seien im folgenden beispielhaft angeführt:

Man unterscheidet Dioden- bzw. Triodenanordnungen, je nachdem, ob das Plasma selbständig zündet oder ob es einer zusätzlichen Elektronenquelle bedarf. Dabei kann sowohl Gleichspannung als auch hochfrequente Wechselspannung zum Einsatz gelangen. Mit derselben aufgefächerten Faseranordnung werden auch plasmaaktivierte und reaktive Verdampfungsprozesse möglich. Zusammenfassend kann man sagen, daß alle Verfahren geeignet sind, die es erlauben, die Wachstumskinetik gezielt zu beeinflussen, sei es über die Temperatur des Substrats, sei es über die kinetische Energie der Reaktanten (Plasmaaktivierung bzw. partielle Gasdrucke).

Zur Beeinflussung der Wachstumskinetik kann in vorteilhafter Weise die Trägerfaser unmittelbar vor und während dem Beschichten durch Infrarotstrahlung temperiert werden. Es kann beispielsweise eine Temperierung des Substrats auf 60 bis 70°C erfolgen. Die Temperaturkontrolle kann durch Infrarotsensoren erfolgen.

Um neben den guten Supraleitungseigenschaften der supraleitenden Schicht auch deren mechanische Eigenschaften zu verbessern, kann ein drittes erfinderisches Verfahren verwendet werden, bei dem ebenfalls das Trägerfaserbündel zu einem Trägerfaserband aufgefächert wird, und sich hieran eine allseitige Beschichtung der Trägerfasern mit Nioboxycarbonitrid durch reaktive Kathodenzerstäubung anschließt. Die thermischen Bedingungen, insbesondere die Temperatur der Trägerfasern werden bei der Abscheidung derart eingestellt, daß sich das Nioboxycarbonitrid in amorpher Form abscheidet. Dabei findet zur exakten Dosierung der Nichtmetallverbindungspartner $O_2$, $N_2$ bzw. C ein Nioboxycarbonitrid-Sintertarget Verwendung. Die amorphe supraleitende Schicht wird durch eine sich an die Abscheidung anschließende Wärmebehandlung (z.B. Erwärmung auf 600 bis 800°C) in eine feinkörnige B1-Struktur übergeführt. Durch dieses Verfahren kann eine völlige Texturfreiheit (Körner weisen keinerlei Vorzugsorientierung auf) erreicht werden, woraus neben den guten Supraleitungseigenschaften besonders gute mechanische Eigenschaften resultieren.

Die Auffächerung des Trägerfaserbündels zu einem Band nebeneinanderliegender Fasern (lineare Anordnung der einzelnen Faserquerschnitte) kann herstellerseitig oder durch nachträgliche Entflechtung erfolgen. Bei einem derartigen Trägerfaserband kann die gegenseitige Abschattung der einzelnen Fasern weitgehend vermieden werden, so daß eine homogene, allseitige Beschichtung der Fasern möglich wird, vor allem dann, wenn eine beidseitige Kathodenzerstäubung vorgenommen wird.

Die Kathodenzerstäubung wird vorteilhaft reaktiv, d.h. bei gleichzeitiger Anwesenheit von Stickstoff oder stickstoffhaltiger Verbindung entweder zweistufig oder einstufig durchgeführt, so daß sich als Endprodukt ein Leiter ergibt, der aus einer Vielzahl von Trägerfasern besteht, die mit einem NbCN-Supraleiter feinster Körnung (3 bis 50 nm) und eienr Schichtstärke von der Größenordnung 1000 nm überzogen sind.

In vorteilhafter Weise erfolgt die reaktive Kathodenzerstäubung in einem fokussierenden Magnetfeld (Magnetron), durch welches auf die Plasmadichte derart eingewirkt wird, daß die Elektronen des Plasmas weitgehend vom Substrat (Faserbündel) ferngehalten werden. Hierdurch wird eine unerwünschte Aufheizung des Substrates vermieden und das Kornwachstum behindert, wodurch die Bildung eines amorphen Vorproduktes begünstigt wird.

Die Überführung des amorphen Vorproduktes in eine feinkörnige B1-Struktur kann durch Temperierung mittels Infrarotstrahlung oder eine andere Erwärmungsart, z.B. in einem Ofen oder durch Elektronenstrahlpuls oder Laserpuls, erfolgen.

Ebenso wie bei dem beschriebenen CVD-Verfahren lassen sich auch durch die physikalischen Aufdampfverfahren Einlagerungen aus isolierendem Material auf den Korngrenzen der supraleitenden Körner bzw. die Leitfähigkeit der supraleitenden Körner erhöhende Legierungen herstellen. Hierbei wird in analoger Weise wie bei den beschriebenen CVD-Prozessen verfahren.

Zur Herstellung von Einlagerungen und Korngrenzenbeschichtungen aus isolierendem Material kann entsprechendes Material simultan mit dem Nioboxycarbonitrid in einem Kathodenzerstäubungsreaktor auf die Trägerfasern aufgebracht werden. Für die Erzeugung eines schichtweisen Aufbaues, bei dem supraleitende und isolierende Schichten abwechselnd aufeinanderfolgen, kann die Zerstäubung des isolierenden Materials alternierend mit dem Nioboxycarbonitrid-Auftrag in einem Kathodenzerstäubungs-Reaktor erfolgen. Die Zerstäubung des isolierenden Material kann hierbei jedoch auch pulsierend bei kontinuierlichem Auftrag von Nioboxycarbonitrid erfolgen.

Schließlich läßt sich für eine Erhöhung der Leitfähigkeit der supraleitenden Körner dem Quellmaterial für die Kathodenzerstäubung ein die Leitfähigkeit erhöhendes Element wie Tantal oder Titan beimischen.

Zur elektrischen Stabilisierung der supraleitenden Fasern und um Kontaktierungsmöglichkeiten zu schaffen, erfolgt vorzugsweise nach Aufbringen der supraleitenden Schicht auf die Trägerfasern durch eines der beschriebenen erfinderischen Verfahren in einem weiteren, sich unmittelbar hieran anschließenden Verfahrensschritt, eine Beschichtung der Fasern mit hochreinem Kupfer oder Aluminium. Diese Beschichtung kann z.B. durch ein chemisches Verfahren (z.B. stromloses naßchemisches Verfahren oder CVD-Verfahren) erfolgen, welches die gleichzeitige und gleichmäßige Verkupferung bzw. Beschichtung mit Aluminium aller Fasern des Faserbündels ermöglicht. Eine thermische Nachbehandlung des Kupfers verbessert dessen Leitfähigkeit. Sofern das Faserbündel aufgefächert ist, eignet sich zur Beschichtung mit Kupfer oder Aluminium auch ein elektrolytisches Beschichtungsverfahren bzw. eine Bedampfung, da in diesem Fall die einzelnen Fasern sich gegenseitig nicht abschirmen bzw. abdecken.

Eine weitere Ausgestaltung des Verfahrens zur Herstellung von supraleitenden Faserbündeln sieht vor, daß die Beschichtung der Trägerfasen in einem kontinuierlichen Prozeß erfolgt, wobei die Trägerfasern von einer Rohmaterialspule abgehaspelt und durch die Beschichtungsanlage transportiert werden und die beschichteten Fasern auf eine Aufnahmespule aufgehaspelt werden. Das Verfahren kann dabei auch in mehreren Schritten (z.B. zwei kontinuierliche Durchläufe durch die Beschichtungsanlage) erfolgen. Ein Unterdruck kann durch starkes Pumpen hergestellt werden. Das Fehlen von Schleusen in der Beschichtungsanlage ist vorteilhaft, da es das Einströmen von Verunreinigungen aus der Außenluft vermeidet. Die beiden Spulen können in Unterdruckbehältern, die direkt, ohne Schleusen an die Beschichtungsanlage anflanschbar sind, untergebracht sein.

Anhand der Zeichnung sollen vorteilhafte Ausgestaltungen der Erfindung erläutert und beschrieben werden.
Es zeigen:
Fig. 1 einen Teil des Querschnittes einer beschichteten Trägerfaser,
Fig. 2 + 3 je den Teilbereich einer supraleitenden Schicht,
Fig. 4 die schematische Darstellung einer CVD-Apparatur zur NbCN-Beschichtung von C-Fasern,
Fig. 5 eine Vorrichtung zum Auffächern und Beschichten der Trägerfasern und eine Verdampfungseinrichtung zum Beschichten des Trägerfaserbandes und
Fig. 6 einen Schnitt VI-VI-der Verdampfungseinrichtung gemäß Fig. 5.

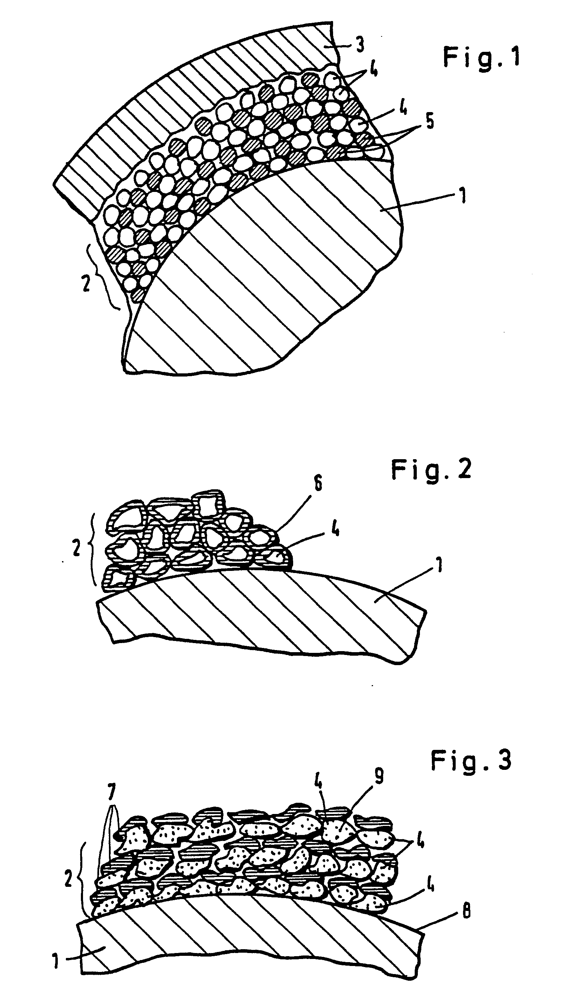

In der Figur 1 ist schematisch ein Teil des Querschnittes einer Trägerfaser 1, z.B. Kohlenstoffaser, stark vergrößert dargestellt, die mit einer supraleitenden Schicht 2 bedeckt ist. Die supraleitende Schicht 2 ist ihrerseits durch eine Schicht 3 aus hochreinem Kupfer beschichtet. Die supraleitende Schicht 2 besteht aus einem Gemisch von supraleitenden Körnern 4 und Körner 5 aus isolierendem Material. Die supraleitenden Körner 4 sind B1-Struktur-Nioboxycarbonitrid-Kristalle, deren mittlere Korngröße zwischen 3 und 50 nm liegt, und deren chemische Formel durch $NbC_xN_yO_z$ (x+y+z kleiner/gleich 1) beschrieben werden kann. Die isolierenden Körner 5 bestehen aus Niobdioxid $NbO_2$. Sie können jedoch auch, wie in der Beschreibungseinleitung erwähnt wurde, ein anderes Oxid, Carbit oder Nitrid enthalten. Die isolierenden Körner 5 haben jeweils eine Größe, die in etwa der Kohärenzlänge des Supraleiters entspricht. Sie liegen an den Korngrenzen der supraleitenden Körner 4 an und wirken als Pinning-Körner. Die Dicke der supraleitenden Schicht 2 liegt zwischen 100 und 2000 nm.

In Figur 2 ist der Teilbereich einer supraleitenden Schicht 2 dargestellt, deren supraleitende Körner 4 durch Niobdioxid oder ein anderes isolierendes Material 6 abgedeckt sind. Das isolierende Material 6 ist im wesentlichen an allen Korngrenzen der B1-Struktur-Nioboxycarbonitrid-Körner 4 unabhängig von der räumlicher Ausrichtung abgeschieden.

Figur 3 zeigt ebenfalls den Teilbereich einer supraleitenden Schicht 2. Die supraleitende Schicht 2 zeigt einen geschichteten Aufbau, bei dem sich Schichten aus supraleitenden Körnern 4 und Schichten aus isolierendem Material 7 (z.B. Niobdioxid) abwechseln. Die Einlagerungen aus isolierendem Material 7 bedecken somit nicht alle Korngrenzen der B1-Struktur-Nioboxycarbonitrid-Körner 4, sondern belegen nur Korngrenzen, die eine Ausrichtung innerhalb der supraleitenden Schicht 2 haben und parallel zur Oberfläche 8 der Trägerfaser 1 liegen. Die supraleitenden Körner 4 enthalten neben dem Nioboxycarbonitrid ein die Leitfähigkeit erhöhendes Element 9, z.B. Tantal oder Titan, was durch Punkte innerhalb der abgebildeten Körner 4 angedeutet ist.

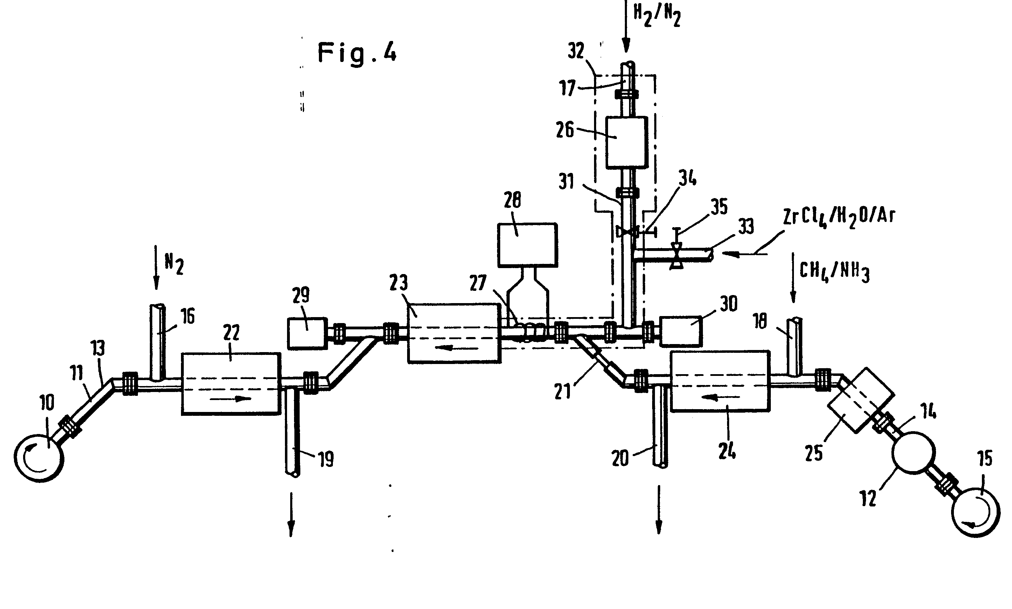

Die Figur 4 zeigt eine Abscheideapparatur, mittels der durch Nioboxycarbonitridabscheidung auf Kohlenstoffasern und anschließender Verkupferung der einzelnen Fasern ein erfindungsgemäßes supraleitendes Faserbündel herstellbar ist.

In einer Abspulkammer 10 befindet sich eine Rohmaterialspule, die die unbeschichteten Trägerfasern 11 (Kohlenstoffasern) trägt. Die Trägerfasern 11 werden durch eine Fasertransporteinrichtung 12 durch ein mehrfach abgewinkeltes Quarzrohr 13, in dem die Beschichtung der Trägerfasern 11 erfolgt, gezogen. Die beschichteten Fasern 14 werden auf eine in einer Aufspulkammer 15 befindliche Aufnahmespule aufgehaspelt. In dem Quarzrohr 13 befinden sich drei Gaseinlaßstutzen 16, 17, 18, durch die Stickstoff $N_2$, ein Gemisch aus Wasserstoff und Stickstoff $H_2/N_2$ bzw. ein Gemisch aus Methan und Ammoniak $CH_4/NH_3$ in das Quarzrohr 13 eingelassen werden können. Über zwei Pumpstutzen 19, 20 läßt sich das innerhalb des Quarzrohres 13 befindliche Gas abpumpen und ein Unterdruck herstellen. Durch eine Drosselstelle 21, durch die sich das Faserbündel ziehen läßt, wird ein Druckausgleich im Quarzrohr 13 verhindert, so daß sich innerhalb des Quarzrohres 13 zwei unterschiedliche Drücke vor und hinter der Drosselstelle 21 einstellen können.

Während ihres Transportes von der Abspulkammer 10 zur Aufspulkammer 15 tritt das Faserbündel durch vier Öfen 22, 23, 24, 25. Im ersten Ofen 22 werden die Kohlenstoffasern 11, falls notwendig, gereinigt, indem sie in einer Stickstoff- oder Wasserstoffatmosphäre aufgeheizt werden. Die Gaszuflußmenge in den Gaseinlaßstutzen 16 liegt beispielsweise zwischen 1 und 20 Liter pro Stunde. Die Ofentemperatur wird auf 600 bis 1000° C eingestellt.

Im zweiten Ofen 23 (CVD-Reaktor) werden die Fasern aus einem $NbCl_5$-$H_2$-$N_2$-Gasgemisch mit einer Nb-

haltigen Verbindung beschichtet. Hierfür strömt durch den Gaseinlaßstutzen 17 ein Wasserstoff-Stickstoff-Gemisch in das Quarzrohr 13 mit einer jeweiligen Zuflußmenge, die zwischen 2 und 20 Liter pro Stunde liegt, ein. Das NbCl$_5$ wird aus einem Feststoffverdampfer 26, der jedoch auch durch einen Verdampfer aus der flüssigen Phase ersetzt werden kann, in die Gasphase überführt und mit dem Wasserstoff-Stickstoff-Gemisch in den Reaktor geleitet. Die Temperatur des Feststoffverdampfers wird hierbei auf einen Wert zwischen 80 und 200°C eingestellt. Das Niobchlorid kann jedoch auch durch direkte Chlorierung von Niob hergestellt werden. Die Temperatur des Ofens 23 liegt zwischen 600 und 1000°C. Das Restgas wird über den Pumpstutzen 19 abgepumpt.

Im dritten Ofen 24 erfolgt die zweite Stufe des CVD-Verfahrens zur Herstellung der supraleitenden Schicht. Durch den Gaseinlaßstutzen 18 wird ein kohlenstoff- und stickstoffhaltiges Gasgemisch (z.B. 0 bis 50 Vol.-% Methan, 0 bis 50 Vol.-% Ammoniak und der Rest Stickstoff) in das Quarzrohr 13 eingelassen. Die Zuflußmenge von Methan und Ammoniak liegt jeweils zwischen 2 und 15 Liter pro Stunde. Der dritte Ofen 24 wird auf eine Temperatur zwischen 700 und 1100°C temperiert. Dabei dissoziieren die Gase Methan und Ammoniak und es dringen Kohlenstoff und Stickstoff in die Niobschicht ein. Das Restgas wird über den Pumpstutzen 20 abgesaugt.

Im Prinzip kann in der Abscheideapparatur auch einstufig gearbeitet werden, d.h. im Ofen 23 wird gleichzeitig Niob abgeschieden und in einer kohlenstoff- und stickstoffhaltigen Atmosphäre carbonitriert.

Das Quarzrohr 13 (Reaktor) und die Gasversorgung ist durch geeignet angebrachte Strömungswiderstände (Drosselstelle 21) und geeignete Auslegung der Pumpen, die an die Pumpstutzen 19, 20 angeschlossen sind, so konstruiert, daß die Gase in den Öfen 22, 23, 24 jeweils in Pfeilrichtung strömen.

Die Niobabscheidung in dem Ofen 23 erfolgt unter Plasmaaktivierung. Hierfür ist dem Ofen 23 eine HF-Spule 27 vorgeschaltet (gemäß der Gasströmungsrichtung im Quarzrohr). Die HF-Spule 27 wird durch einen HF-Generator 28 mit einer Frequenz von 13,65 MHz gespeist. Die Leistung des HF-Generators 28 liegt beispielsweise zwischen 5 und 100 Watt. Die Spule 27 hat beispielsweise eine Länge von 80 mm, einen Durchmesser von 55 mm und trägt dreizehn Windungen. Die Plasmaaktivierung kann auch - was nicht dargestellt wurde - kapazitiv oder durch eine Gleichstromentladung erfolgen. Hierfür stehen sich zwei im Quarzrohr 13 radial gegenüberliegende Metallstäbe bzw. Platten als Elektroden gegenüber. Durch die HF-Spule bzw. die Elektroden werden die Reaktanten (Gase) innerhalb des Quarzrohres 13 in einen angeregten oder ionisierten Zustand gebracht. Die Gasentladung kann kontinuierlich oder pulsierend angeregt werden.

Die Niobabscheidung im Ofen 23 kann auch unter Einwirkung eines Ultraschallfeldes erfolgen. Das Ultraschallfeld kann beispielsweise durch einen Piezo-Kristall 29 erzeugt werden, der in Faserrichtung verlaufende Schallwellen aussendet. An einem Schallreflektor 30 reflektieren sich die Schallwellen, so daß die Ausbildung stehender Schallwellen möglich ist. Es hat sich gezeigt, daß die Ausbildung von stehenden Schallwellen bei der Niobabscheidung nicht notwendig ist und daß die Einspeisung des Ultraschalls auch über abgewinkelte Stutzen erfolgen kann. Es ist daher auch möglich, das Quarzrohr 13 in gestreckter Form, ohne Abwinklungen auszubilden, wodurch gegenüber der dargestellten Abscheideapparatur auf mehrere Umlenkungen des Faserbündels verzichtet werden kann. Die Niobabscheidung kann bei einem Schalldruckpegel zwischen 10 und 30 dB und einer Frequenz zwischen 15 und 20 kHz erfolgen.

Das Quarzrohr 31 zwischen Feststoffverdampfer 26 und Ofen 23 wird zweckmäßigerweise zur Aufrechterhaltung der Gastemperatur thermostabilisiert. Dies wurde durch eine strich-punktierte Linie 32 angedeutet.

In dem Ofen 25 werden die supraleitenden Schichten des Faserbündels mit einer hochleitfähigen Kupferschicht überzogen. Dies erfolgt durch einen CVD-Prozeß, bei dem Kupfer aus der Gasphase auf die Fasern abgeschieden wird. Der Ofen 24 kann so temperiert werden, daß die Fasern kälter als das abzuscheidende Kupfer sind.

Im folgenden sollen einige, für die dargestellte Abscheideapparatur vorteilhafte Verfahrensparameter zusammengestellt werden:

Temperaturen:

$T_{NbC15(Kolonne)} = 113^oC$

$T_{Verdampfer} = 138^oC$

$T_{Ofen\ 22} = 1000^oC$

$T_{Ofen\ 23} = 970^oC$

$T_{Ofen\ 24} = 1100^oC$

Druck:

$p = 0,8\ mbar$

Gaszuflußmengen:

$i_{16}(N2) = 1,2\ lh^{-1}$

$i_{17}(N2) = 2,4\ lh^{-1}$

$i_{17}(H2) = 2,4\ lh^{-1}$

$i_{18}(NH3) = 2,4\ lh^{-1}$

$i_{18}(CH4) = 2,4\ lh^{-1}$

Fasergeschwindigkeit: $V_{Faser} = 6\ cm\ min^{-1}$

HF-Generator-Leistung: $N = 40\ Watt$

HF-Frequenz: $f = 13,65\ MHz$

Schalldruckpegel: $S = 15\ dB$

Schallfrequenz: $f_S = 18\ kHz$

Bei der Abscheideapparatur gemäß Figur 4 ist an dem Quarzrohr 31, das zwischen Feststoffverdampfer 26 und Ofen 23 liegt, ein weiteres Quarzrohr 33 angeflanscht, durch das Zirkoniumtetrachlorid $ZrCl_4$, Wasser $H_2O$ und das Trägergas Argon Ar in die Abscheideapparatur eingeleitet werden können. Der Zusatz dieser Gase dient der Herstellung von Kornstrukturen mit Einlagerungen von isolierenden Materialien (hier $ZrO_2$) an den Korngrenzen der supraleitenden Körner. Zu diesem Zweck können auch andere Verbindungen in das Quarzrohr 33 eingeleitet werden. Beispielsweise können durch folgende Reaktionen isolierende Einlagerungen aus der Gasphase abgeschieden werden:

1. $ZrCl_4 + 2H_2O \longrightarrow ZrO_2 + 4HCl$

2) $TiCl_4 + 2H_2O \longrightarrow TiO_2 + 4HCl$

3) $NbCl_4 + H_2O \longrightarrow NbO_2 + 4HCl$

4) $Si(CH_3)Cl_3 \longrightarrow SiC + ....$

5) $TiCl_4 + CH_4 \longrightarrow TiC + ....$

6) $TiCl_4 + NH_3 \longrightarrow TiN + ....$

wobei das $H_2O$ in den Reaktionen 1-3 im Prinzip auch durch die Reaktion
$$CO_2 + H_2 \rightarrow CO + H_2O$$
im Reaktor hergestellt werden kann. Die Reaktionstemperaturen liegen zwischen 1000° und 1100°C, also im selben Bereich wie die Nioboxycarbonitrid-Abscheidung. Den Reaktionssgasen wird zweckmäßigerweise ein Trägergas (z.B. Argon) beigemischt, wodurch sich die Dosierung und Konzentration der Reaktionsgase in der Abscheideapparatur besser einstellen lassen.

Die isolierenden Materialien können auf verschiedene Art in Verbindung mit der Nioboxycarbonitrid-Schicht abgeschieden werden:

1.

Die Abscheidung der isolierenden Materialien erfolgt simultan mit der Nioboxycarbonitrid-Abscheidung, in dem die entsprechenden Gase durch die beiden Quarzrohre 31 und 33 in den Reaktor (Ofen 23) eingeleitet werden. Hierbei scheidet sich ein isolierender Niederschlag auf allen Korngrenzen der supraleitenden Körner bzw. als körnige Einlagerung zwischen den supraleitenden Körnern ab.

2.

Die Abscheidung von supraleitendem und isolierendem Material erfolgt alternierend. Für ein derartiges Verfahren sind in den Quarzrohren 31 und 33 je ein Absperrventil 34 und 35 vorgesehen, die periodisch, gegensinnig geöffnet und geschlossen werden. Hierbei wird auf der Trägerfaser das supraleitende und das isolierende Material schichtweise, z.B. gemäß Fig. 3, aufgetragen.

3.

Für einen schichtweisen Auftrag von supraleitenden und isolierenden Schichten ist auch ein Betrieb der Abscheideapparatur geeignet, bei dem das Absperrventil 34 ständig geöffnet bleibt und lediglich das Absperrventil 35 periodisch geöffnet und geschlossen wird (pulsierender Betrieb).

Durch das Quarzrohr 33 kann auch während der Nioboxycarbonitrid-Abscheidung Tantalpentachlorid $TaCl_5$ oder Titantetrachlorid $TiCl_4$ simultan dem Reaktionsgemisch zugegeben werden. Bei der CVD-Abscheidung wird infolge dieser Zugabe in den supraleitenden Körnern Tantal Ta bzw. Titan Ti abgeschieden. Diese Elemente haben die Eigenschaft, die Leitfähigkeit der supraleitenden Körner zu erhöhen, ohne daß der Wert des kritischen Magnetfeldes $H_{C2}$ wesentlich geändert wird.

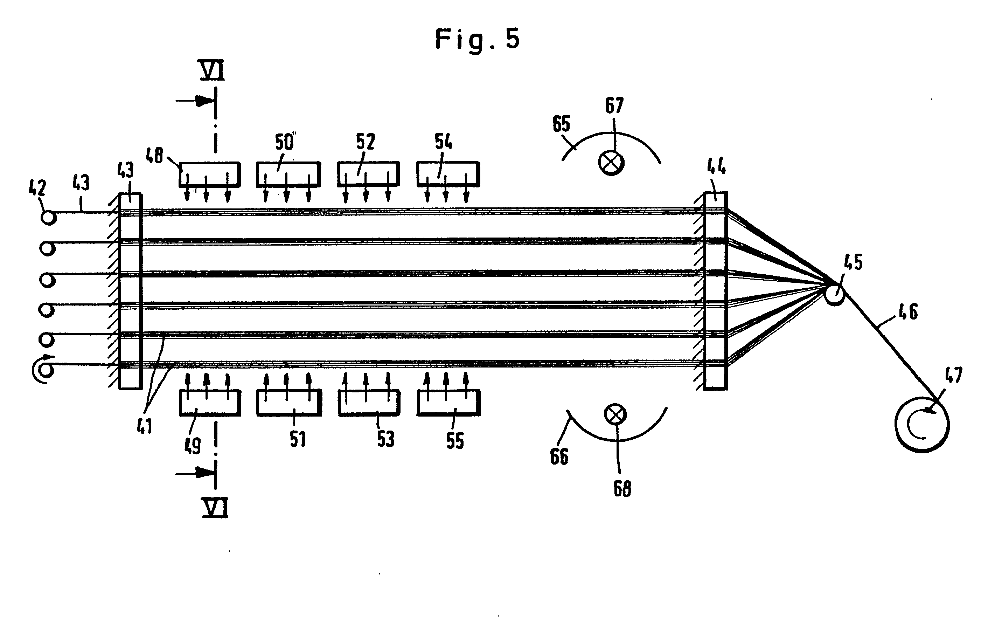

Sofern die Beschichtung der Trägerfasern durch ein physikalisches Verfahren, wie die reaktive Kathoden-Zerstäubung (sputtern), erfolgen soll, muß das Trägerfaserbündel, wie eingangs erwähnt wurde, zu einem Trägerfaserband aufgefächert werden. Die Figur 5 zeigt eine Vorrichtung zum Auffächern der Trägerfasern 40 zu einem Trägerfaserband 41. Dei Trägerfasern 40 werden von mehreren Rohmaterialspulen 42, auf die jeweils eine Vielzahl paralleler, zu einem Trägerfaserbündel zusammengefaßter Trägerfasern 40 aufgehaspelt sind, abgespult und durch einen ersten Kamm 43 gezogen. Durch den Kamm 43 werden die unbeschichteten Trägerfasern 40 zu einem Trägerfaserband 41 aufgefächert. Zwischen dem ersten Kamm 43 und einem zweiten Kamm 44 verlaufen die einzelnen Trägerfasern im wesentlichen parallel und liegen in einer Ebene nebeneinander. Im Bereich des Trägerfaserbandes 41 erfolgt die physikalische Beschichtung der Trägerfasern 40 mit einer supraleitenden Nioboxycarbonitridschicht. Gegebenenfalls kann in einem derart aufgefächerten Bereich auch eine Beschichtung der Fasern mit hochreinem Kupfer oder Aluminium erfolgen, sofern hierfür ein physikalisches Verfahren Verwendung finden soll. Eine Umlenkrolle 45 faßt das Trägerfaserband 41 zu einem beschichteten Faserbündel 46 zusammen. Das Faserbündel 46 wird auf eine Aufnahmespule 47 aufgehaspelt.

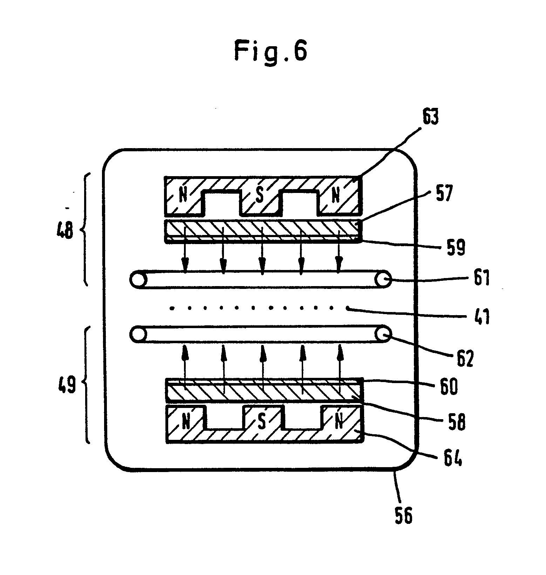

Zwischen den beiden Kämmen 43 ,44 durchläuft das Trägerfaserband 41 eine Verdampfungseinrichtung zur Beschichtung der Trägerfasern 40 mit einer supraleitenden Nioboxycarbonitridschicht. Das Trägerfaserband 41 durchläuft mehrere (gemäß Figur 5 vier) Zerstäubungsanlagen 48,49, 50,51, 52,53, 54,55, die in der Figur 5 der besseren Übersichtlichkeit wegen an den Trägerfaserbandrändern eingezeichnet sind, tatsächlich sich jedoch beidseitig der durch das Trägerfaserband 41 aufgespannten Ebene angeordnet sind, was aus der Figur 6 hervorgeht, die einen Schnitt VI-VI durch zwei Zerstäubungsanlagen 48,49 darstellt.

Die Figur 6 zeigt die Wandung 56 eines Reaktors, der für die Aufrechterhaltung des Plasmas mit dem Trägergas Argon Ar bei einem Unterdruck von wenigen mbar gefüllt ist. Durch den Reaktor wird das aufgefächerte Trägerfaserbündel 41 gezogen. Beidseitig der durch das Trägerfaserband 41 aufgespannten Ebene sind zwei Zerstäubungsanlagen 48,49 angeordnet. Jede Zerstäubungsanlage 48,49 besteht aus einem auf eine Kathode 57,58 aufgebrachten Nioboxycarbonitrid-Sintertarget 59,60 sowie einer Anode 61,62. Die Zerstäubung des Nioboxycarbonitrid erfolgt in Pfeilrichtung. Auf der dem Trägerfaserband 41 abgewandten Seite der Kathode 57,58 befindet sich eine Magnetanordnung 63,64. Die Magnetanordnung 63,64 ist im Schnitt dargestellt. Sie kann beispielsweise als Ringanordnung ausgebildet sein, bei der in der Mitte ein Südpol S ausgebildet ist, der ringförmig durch mehrere Nordpole N umgeben ist. Diese Magnetanordnung 63,64 hat die Aufgabe, das Plasma unmittelbar vor der Kathode zu konzentrieren. Die bei der Zerstäubung freiwerdenden Elektronen fließen entweder zu der im unmittelbaren Kathodenbereich angeordneten Anoden 61,62 oder zur Wandung 56 des Reaktors. Das Trägerfaserband 41 ist dem Materialfluß des zerstäubenden Materials (Nioboxycarbonitrid) und nur zu einem geringen Teil dem Bombardement von Sekundärelektronen ausgesetzt. Auf diese Weise läßt sich eine unerwünschte Aufheizung des Substrates (Trägerfaserband) vermeiden.

Zur Herstellung eines Multilayer-Aufbaues der supraleitenden Schicht besteht, wie aus Fig. 5 ersichtlich, die Verdampfugnseinrichtung aus mehreren hintereinander geschalteten Zerstäubungsaanlagen 48,49, 50,51, 52,53, 54,55. In dem ersten und dritten Satz der Zerstäubungsanlagen 48,49, 52,53 erfolgt eine Beschichtung mit Nioboxycarbonitrid. In dem zweiten und vierten Satz der Zerstäubungsanlagen 50,51, 54,55 enthält das Target ein isolierendes Material, so daß hier jeweils zwischen zwei supraleitenden Schichten eine isolierende Schicht aufgetragen wird. Als isolierende Materialien kommen hier (wie beim CVD-Verfahren) Oxide ($ZrO_2$, $TiO_2$, $NbO_2$), Carbide (SiC, TiC) oder Nitride (TiN) in Frage.

Durch die beschriebene Verdampfungseinrichtung läßt sich auch eine supraleitende Schicht auf die Trägerfasern aufbringen, bei der die isolierenden Einlagerungen gleichmäßig in der supraleitenden Schicht verteilt sind. Hierfür wird ein entsprechendes Mischtarget aus Nioboxycarbonitrid und einem entsprechenden isolierenden Material verwendet.

Bei Verwendung eines Mischtargets, welches neben dem Nioboxycarbonitrid ein Element wie Tantal Ta oder Titan Ti enthält, läßt sich eine supraleitende Schicht herstellen, deren supraleitendes Material neben dem Nioboxycarbonitrid ein weiteres Element enthält, welches die Leitfähigkeit der supraleitenden Körner erhöht.

Im Anschluß an die physikalische Beschichtung durchläuft das Trägerfaserband 41 eine Wärmebehandlungseinrichtung, die gemäß der Fig. 5 durch zwei mit Reflektoren 65,66 versehene Infrarotstrahler 67,68 gebildet ist. Die thermischen Bedingungen werden so eingestellt, daß die amorphe Nioboxycarbonitrid-Verbindung, die in den Zerstäubungsanlagen 48,49, 52,53 auf das Trägerfaserband 41 aufgetragen wurde, in eine feinkörnige B1-Struktur übergeführt wird, deren mittlere Korngröße zwischen 3 und 50 nm liegt. Beispielsweise wird das beschichtete Faserbündel auf 600° bis 800°C für ca. 10 Minuten aufgeheizt.

## Patentansprüche

1. Supraleitendes Faserbündel, das aus einer Vielzahl mit einer supraleitenden Schicht (2) aus einer Niobverbindung der allgemeinen Formel $NbC_xN_yO_z$ ($x+y+z$ kleiner/gleich 1) beschichteten Trägerfasern (1), wie z.B. Kohlenstoffasern, Borfasern, Stahlfasern besteht, dadurch gekennzeichnet, daß das supraleitende Material der supraleitenden Schicht (2) aus feinkörnigem B1-Struktur-Nioboxycarbonitrid oder -Niobcarbonitrid besteht, dessen mittlere Korngröße zwischen 3 und 50 nm liegt.

2. Supraleitendes Faserbündel nach Anspruch 1, dadurch gekennzeichnet, daß die Schichtdicke der supraleitenden Schicht (2) zwischen 100 und 2000 nm liegt.

3. Supraleitendes Faserbündel nach einem der Ansprüche 1 oder 2, dadurch gekennzeichnet, daß die supraleitende Schicht (2) mit einer hochleitfähigen Metallschicht (3), beispielsweise aus hochreinem Kupfer oder Aluminium, überzogen ist.

4. Supraleitendes Faserbündel nach einem der Ansprüche 1 bis 3, dadurch gekennzeichnet, daß die supraleitende Schicht (2) zwischen den B1-Struktur-Nioboxycarbonitrid-Körner (4) gleichmäßig verteilt Einlagerungen (5) aus isolierendem Material enthält.

5. Supraleitendes Faserbündel nach einem der Ansprüche 1 bis 3, dadurch gekennzeichnet, daß in der supraleitenden Schicht (2) Einlagerungen aus isolierendem Material (6) an allen Korngrenzen der B1-Struktur-Nioboxycarbonitrid-Körner, unabhängig von deren räumlicher Ausrichtung, abgeschieden sind.

6. Supraleitendes Faserbündel nach einem der Ansprüche 1 bis 3, dadurch gekennzeichnet, daß in der supraleitenden Schicht (2) Einlagerungen aus isolierendem Material (7) an Korngrenzen der B1-Struktur-Nioboxycarbonitrid-Körner, die parallel zur Oberfläche (8) der jeweiligen Trägerfaser (1) liegen, abgeschieden sind, so daß ein Vielschichtaufbau entsteht, bei dem sich supraleitendes Material und isolierendes Material abwechseln.

7. Supraleitendes Faserbündel nach einem der Ansprüche 1 bis 6, dadurch gekennzeichnet, daß das supraleitende Material (4) neben dem Nioboxycarbonitrid ein weiteres, die Leitfähigkeit erhöhendes Element (9), vorzugsweise Tantal oder Titan, enthält.

8. Verfahren zur Herstellung von supraleitenden Faserbündeln nach einem der Ansprüche 1 bis 7, bei dem in einem CVD-Reaktor (23) das Nioboxycarbonitrid mit Hilfe der chemischen Abscheidung aus der Gasphase durch Reaktion von Niobchlorid, Kohlenstoff- und Stickstoffverbindungen auf der Trägerfaser (11) abgeschieden wird, dadurch gekennzeichnet, daß die Abscheidung aus der Gasphase unter Einsatz von Plasmaaktivierung und bei einem Gasgesamtdruck zwischen 0,1 und 5 mbar erfolgt.

9. Verfahren, vorzugsweise nach Anspruch 8, zur Herstellung von supraleitenden Faserbündeln nach einem der Ansprüche 1 bis 7, bei dem in einem CVD-Reaktor (23) das Nioboxycarbonitrid mit Hilfe der chemischen Abscheidung aus der Gasphase durch Reaktion von Niobchlorid, Kohlenstoff- und Stickstoffverbindungen auf der Trägerfaser (11) abgeschieden wird, dadurch gekennzeichnet, daß die Abscheidung aus der Gasphase unter Einwirkung eines Ultraschallfeldes und bei einem Gasgesamtdruck zwischen 0,1 und 1000 mbar erfolgt.

10. Verfahren nach Anspruch 8 und/oder 9 zur Herstellung von supraleitenden Faserbündeln nach Anspruch 4 oder 5, dadurch gekennzeichnet, daß in dem CVD-Reaktor (23) simultan zur Nioboxycarbonitrid-Abscheidung das isolierenden Material (5, 6) aus der Gasphase abgeschieden wird.

11. Verfahren nach Anspruch 8 und/oder Anspruch 9 zur Herstellung von supraleitenden Faserbündeln nach Anspruch 6, dadurch gekennzeichnet, daß in dem CVD-Reaktor (23) das Nioboxycarbonitrid und das isolierende Material (7) alternierend aus der Gasphase abgeschieden werden.

12. Verfahren nach Anspruch 8 und/oder Anspruch 9 zur Herstellung von supraleitenden Faserbündeln nach Anspruch 6, dadurch gekennzeichnet, daß in dem CVD-Reaktor (23) bei kontinuierlicher Abscheidung von Nioboxycarbonitrid das isolierende Material (7) pulsierend aus der Gasphase abgeschieden wird.

13.. Verfahren nach einem der Ansprüche 8 bis 12 zur Herstellung von supraleitenden Faserbündeln nach Anspruch 7, dadurch gekennzeichnet, daß in dem CVD-Reaktor (23) simultan zur Nioboxycarbonitrid-Abscheidung ein die Leitfähigkeit erhöhendes Element (9) aus der Gasphase abgeschieden wird.

14. Verfahren zur Herstellung von supraleitenden Faserbündeln nach einem der Ansprüche 1 bis 7, dadurch gekennzeichnet, daß ein Trägerfaserbündel zu einem Trägerfaserband (41) aufgefächert wird, und daß sich hieran eine allseitige Beschichtung der Trägerfasern (40) mit Nioboxycarbonitrid durch Kathodenzerstäubung, insbesondere reaktive Kathodenzerstäubung, von Niob bei gleichzeitiger Anwesenheit von Stickstoff oder einer Stickstoffverbindung und Kohlenstoff oder einer Kohlenstoffverbindung anschließt, wobei das Trägerfaserband (41) gegebenenfalls derart temperiert wird, daß sich das Nioboxycarbontrid in polykristalliner Struktur abscheidet.

15. Verfahren nach Anspruch 14, dadurch gekennzeichnet, daß die Trägerfasern (40) unmittelbar vor oder während dem Beschichten durch Infrarotstrahlung temperiert werden.

16. Verfahren zur Herstellung eines supraleitenden Faserbündels nach einem der Ansprüche 1 bis 7, dadurch gekennzeichnet, daß ein Trägerfaserbündel (41) zu einem Trägerfaserband aufgefächert wird, daß sich hieran bei entsprechender Temperaturkontrolle der Trägerfasern (40) eine allseitige Beschichtung der Trägerfasern (40) mit Nioboxycarbonitrid in amorpher Form durch reaktive Kathodenzerstäubung anschließt, wobei zur exakten Dosierung der Nichtmetallverbindungspartner $O_2$, $N_2$ bzw. C ein Nioboxycarbontrid-Sintertarget (59,60) Verwendung findet, und daß in einer anschließenden Wärmebehandlung die amorphe Nioboxycarbonitrid-Verbindung in die feinkörnige B1-Struktur übergeführt wird.

17. Verfahren nach einem der Ansprüche 14 bis 16, dadurch gekennzeichnet, daß die reaktive Kathodenzerstäubung in einem fokussierenden Magnetfeld erfolgt, durch welches auf die Plasmadichte derart eingewirkt wird, daß die Elektronen des Plasmas weitgehend vom Substrat ferngehalten werden.

18. Verfahren nach einem der Ansprüche 14 bis 17 zur Herstellung von supraleitenden Faserbündeln nach Anspruch 4 oder 5, dadurch gekennzeichnet, daß simultan zur Beschichtung der Trägerfasern (40) mit Nioboxycarbonitrid durch Kathodenzerstäubung isolierendes Material (5, 6) durch Kathodenzerstäubung auf die Trägerfasern (40) aufgebracht wird.

19. Verfahren nach einem der Ansprüche 14 bis 17 zur Herstellung von supraleitenden Faserbündeln nach Anspruch 6, dadurch gekennzeichnet, daß in einem Reaktor (56) für die Kathodenzerstäubung das Nioboxycarbonitrid und das isolierende Material (7) alternierend auf die Trägerfasern (40) aufgebracht wird.

20. Verfahren nach einem der Ansprüche 14 bis 17 zur Herstellung von supraleitenden Faserbündeln nach Anspruch 6, dadurch gekennzeichnet, daß hei kontinuierlicher Beschichtung der Trägerfasern (40) mit Nioboxycarbonitrid durch Kathodenzerstäubung das isolierende Material (7) pulsierend durch Kathodenzerstäubung auf die Trägerfasern (40) aufgebracht wird.

21. Verfahren nach einem der Ansprüche 14 bis 20 zur Herstellung von supraleitenden Faserbündeln nach Anspruch 7, dadurch gekennzeichnet, daß in dem Kathodenzerstäubungs-Reaktor (56) simultan zur Nioboxycarbonitrid-Beschichtung ein die Leitfähigkeit erhöhendes Element (9) durch Kathodenzerstäubung auf die Trägerfasern (40) aufgebracht wird.

22. Verfahren nach einem der Ansprüche 8 bis 21, dadurch gekennzeichnet, daß nach Aufbringen der supraleitenden Schicht (2) auf die Trägerfasern (1, 11, 40) in einem weiteren, sich unmittelbar hieran anschließenden Verfahrensschritt, eine Beschichtung der Fasern mit hochreinem Kupfer oder Aluminium erfolgt.

23. Verfahren nach einem der Ansprüche 8 bis 22, dadurch gekennzeichnet, daß die Beschichtung der Trägerfasen in einem kontinuierlichen Prozeß erfolgt, wohei die Trägerfasern (1, 11, 40) von einer Rohmaterialspule (10, 42) abgehaspelt und durch die Beschichtungsanlage transportiert werden und die beschichteten Fasern auf eine Aufnahmespule (15, 47) aufgehaspelt werden.

## Claims

1. Superconducting fibre bundle which consists of a multiplicity of carrier fibres (1) such as, for example, carbon fibres, boron fibres, steel fibres, coated with a superconducting layer (2) consisting of a niobium compound of the general formula $NbC_xN_yO_z$ ($x+y+z$ less than /equal to 1) characterized in that the superconducting material of the superconducting layer (2) consists of fine-grain niobium oxycarbonitride or niobium carbonitride with B1 (sodium chloride) structure whose mean grain size is between 3 and 50 nm.

2. Superconducting fibre bundle according to Claim 1, characterized in that the layer thickness of the superconducting layer (2) is between 100 and 2,000 nm.

3. Superconducting fibre bundle according to one of the Claims 1 or 2, characterized in that the superconducting layer (2) is covered with a highly conductive metal layer (3), for example of high-purity copper or aluminium.

4. Superconducting fibre bundle according to one of the Claims 1 to 3, characterized in that the superconducting layer (2) contains inclusions (5) of insulating material uniformly distributed between the niobium oxycarbonitride grains with B1 structure.

5. Superconducting fibre bundle according to one of the Claims 1 to 3, characterized in that, in the superconducting layer (2), inclusions of insulating material (6) are deposited at all grain boundaries of the niobium oxycarbonitride grains with B1 structure, regardless of their spatial alignment.

6. Superconducting fibre bundle according to one of the Claims 1 to 3, characterized in that, in the superconducting layer (2), inclusions of insulating material (7) are deposited at grain boundaries of the niobium oxycarbonitride grains with B1 structure which are parallel to the surface (8) of the respective carrier fibre (1) so that a multi-layer structure is produced in which superconducting material and insulating material alternate with each other.

7. Superconducting fibre bundle according to one of the Claims 1 to 6, characterized in that the superconducting material (4) contains, in addition to the niobium oxycarbonitride, a further element (9) which increases the conductivity, preferably tantalum or titanium.

8. Process for the manufacture of the superconducting fibre bundles according to one of the Claims 1 to 7 in which the niobium oxycarbonitride is deposited on the carrier fibre (11) in a CVD (chemical vapour deposition) reactor (23) by means of chemical deposition from the gas phase by reaction of niobium chloride, carbon compounds and nitrogen compounds, characterized in that the deposition from the gas phase takes place using plasma activation and at a total gas pressure between 0.1 and 5 mbar.

9. Process, preferably according to Claim 8, for the manufacture of superconducting fibre bundles according to one of the Claims 1 to 7 in which the niobium oxycarbonitride is deposited on the carrier fibre (11) in a CVD reactor (23) by means of chemical deposition from the gas phase by reaction of niobium chloride, carbon compounds and nitrogen compounds, characterized in that the deposition from the gas phase takes place under the influence of an ultrasonic field and at a total gas pressure between 0.1 and 1,000 mbar.

10. Process according to Claim 8 and/or 9 for the manufacture of superconducting fibre bundles according to Claim 4 or 5, characterized in that the insulating material (5, 6) is deposited from the gas phase in the CVD reactor (23) simultaneously with the deposition of the niobium oxycarbonitride.

11. Process according to Claim 8 and /or Claim 9 for the manufacture of superconducting fibre bundles according to Claim 6, characterized in that the niobium oxycarbonitride and the insulating material (7) are alternately deposited from the gas phase in the CVD reactor (23).

12. Process according to Claim 8 and/or Claim 9 for the manufacture of superconducting fibre bundles according to Claim 6, characterized in that the insulating material (7) is pulsatingly deposited from the gas phase in the CVD reactor (23) with continuous deposition of niobium oxycarbonitride.

13. Process according to one of the Claims 8 to 12 for the manufacture of superconducting fibre bundles according to Claim 7, characterized in that an element (9) which increases the conductivity is deposited from the gas phase in the CVD reactor (23) simultaneously with the deposition of the niobium oxycarbonitride.

14. Process for the manufacture of superconducting fibre bundles according to one of the Claims 1 to 7, characterized in that a carrier fibre bundle is fanned out to form a carrier fibre strip (41), and that this is followed by an all-round coating of the carrier fibres (40) with niobium oxycarbonitride by cathode sputtering, in particular reactive cathode sputtering, of niobium with nitrogen or a nitrogen compound and carbon or a carbon compound present at the same time, the carrier fibre strip (41) being heated, if necessary, in a manner such that the niobium oxycarbonitride deposits with polycrystalline structure.

15. Process according to Claim 14, characterized in that the carrier fibres (40) are heated by infra-red radiation immediately before or during the coating.

16. Process for the manufacture of a superconducting fibre bundle according to one of the Claims 1 to 7, characterized in that a carrier fibre bundle (41) is fanned out to form a carrier fibres strip, that this is followed by an all-round coating of the carrier fibres (40) with niobium oxycarbonitride in amorphous form by reactive cathode sputtering with appropriate temperature control, a niobium oxycarbonitride cintered target (59, 60) is used to achieve exact dosing of the non-metallic compound partner $O_2$, $N_2$ or C respectively and that, in a subsequent thermal treatment, the amorphous niobium oxycarbonitride compound is converted into the fine-grain B1 structure.

17. Process according to one of Claims 14 to 16, characterized in that the reactive cathode sputtering takes place in a focusing magnetic field which affects the plasma density in a manner such that the electrons of the plasma are substantially kept away from the substrate.

18. Process according to one of the Claims 14 to 17 for the manufacture of superconducting fibre bundles according to Claim 4 or 5, characterized in that, simultaneously with the coating of the carrier fibres (40) with niobium oxycarbonitride by cathode sputtering, insulating material (5, 6) is deposited on the carrier fibres (40) by cathode splattering.

19. Process according to one of the Claims 14 to 17 for the manufacture of superconducting fibre bundles according to Claim 6, characterized in that the niobium oxycarbonitride and the insulating material (7) are alternately deposited on the carrier fibres (40) in a reactor (56) for cathode sputtering.

20. Process according to one of the Claims 14 to 17 for the manufacture of superconducting fibre bundles accccording to Claim 6, characterized in that the insulating material (7) is pulsatingly deposited on the carrier fibres (40) by cathode splattering with continuous coating of the carrier fibres (40) with niobium oxycarbonitride by cathode splattering.

21. Process according to one of the Claims 4 to 20 for the manufacture of superconducting fibre bundles according to Claim 7, characterized in that an element (9) which increases the conductivity is deposited on the carrier fibres (40) by cathode splattering in the cathode sputtering reactor (56) simultaneously with the coating with niobium oxycarbonitride.

22. Process according to one of the Claims 8 to 21, characterized in that, after the deposition of the superconducting layer (2) on the carrier fibres (1, 11, 40) a coating of the fibres with high-purity copper or aluminium takes place in a further process step immediately subsequent thereto.

23. Process according to one of the Claims 8 to 22, characterized in that the coating of the carrier fibres takes place in a continuous process, the carrier fibres (1, 11, 40) being unwound from a raw-material reel (10, 42) and being conveyed through the coating system and the coated fibres being wound onto a take-up reel (15, 47).

**Revendications**

1. Faisceau de fibres supraconducteur qui est constitué de plusieurs fibres de support (1), telles que par exemple des fibres de carbone, des fibres de bore, des fibres d'acier, revêtues d'une couche supraconductrice (2) constituée d'un composé à base de niobium, de formule générale $NbC_xN_yO_z$ $(x+y+z \leqq 1)$, caractérisé par le fait que le matériau supraconducteur de la couche supraconductrice (2) est constitué d'oxycarbonitrure de niobium ou de carbonitrure de niobium de structure B1, à grains fins, dont la taille moyenne de grain est comprise entre 3 et 50 nm.

2. Faisceau de fibres supraconducteur selon la revendication 1, caractérisé par le fait que l'épaisseur de couche de la couche supraconductrice (2) est comprise entre 100 et 2000 nm.

3. Faisceau de fibres supraconducteur selon la revendication 1 ou 2, caractérisé par le fait que la couche supraconductrice (2) est revêtue d'une couche métallique très conductrice (3), constituée par exemple de cuivre ou d'aluminium très pur.

4. Faisceau de fibres supraconducteur selon l'une des revendications 1 à 3, caractérisé par le fait que la couche supraconductrice (2) contient des inclusions (5) constituées d'un matériau isolant, réparties uniformément entre les grains d'oxycarbonitrure de niobium de structure B1 (4).

5. Faisceau de fibres supraconducteur selon l'une des revendications 1 à 3, caractérisé par le fait que dans la couche supraconductrice (2), des inclusions constituées d'un matériau isolant (6) sont déposées à tous les joints de grains des grains d'oxycarbonitrure de niobium de structure B1, indépendamment de l'orientation spatiale de ceux-là.

6. Faisceau de fibres supraconducteur selon l'une des revendications 1 à 3, caractérisé par le fait que dans la couche supraconductrice (2), des inclusions constituées d'un matériau isolant (7) sont déposées aux joints de grains des grains d'oxycarbonitrure de niobium de structure B1 qui sont disposés parallèlement à la surface (8) de la fibre de support respective (1), si bien qu'il en résulte une configuration multicouche, dans laquelle alternent matériau supraconducteur et matériau isolant.

7. Faisceau de fibres supraconducteur selon l'une des revendications 1 à 6, caractérisé par le fait que le matériau supraconducteur (4) contient, en plus de l'oxycarbonitrure de niobium, un autre élément (9) augmentant la conductivité, de préférence du tantale ou du titane.

8. Procédé pour la fabrication de faisceaux de fibres supraconducteurs selon l'une des revendications 1 à 7, dans lequel l'oxycarbonitrure de niobium est déposé sur la fibre de support (11), dans un réacteur CVD (pour dépôt chimique en phase vapeur) (23), au moyen du dépôt chimique à partir de la phase gazeuse, par réaction de chlorure de niobium, de composés carbonés et de composés azotés, caractérisé par le fait que le dépôt à partir de la phase gazeuse est effectué avec utilisation d'une activation par plasma et à une pression totale de gaz comprise entre 0,1 et 5 mbars.

9. Procédé, de préférence selon la revendication 8, pour la fabrication de faisceaux de fibres supraconducteurs selon l'une des revendications 1 à 7, dans lequel l'oxycarbonitrure de niobium est déposé sur la fibre de support (11), dans un réacteur CVD (23), au moyen du dépôt chimique à partir de la phase gazeuse, par réaction de chlorure de niobium, de composés carbonés et de composés azotés, caractérisé par le fait que le dépôt à partir de la phase gazeuse est effectué sous l'effet d'un champ ultrasonique et à une pression totale de gaz comprise entre 0,1 et 1000 mbars.

10. Procédé selon la revendication 8 et/ou la revendication 9 pour la fabrication de faisceaux de fibres supraconducteurs selon la revendication 4 ou 5, caractérisé par le fait que, dans le réacteur CVD (23), le matériau isolant (5, 6) est déposé à partir de la phase gazeuse, en même temps que s'effectue le dépôt de l'oxycarbonitrure de niobium.

11. Procédé selon la revendication 8 et/ou la revendication 9 pour la fabrication de faisceaux de fibres supraconducteurs selon la revendication 6, caractérisé par le fait que, dans le réacteur CVD (23), l'oxycarbonitrure de niobium et le matériau isolant (7) sont déposés en alternance à partir de la phase gazeuse.

12. Procédé selon la revendication 8 et/ou la revendication 9 pour la fabrication de faisceaux de fibres supraconducteurs selon la revendication 6, caractérisé par le fait que, dans le réacteur CVD (23), le matériau isolant (7) est déposé par impulsions à partir de la phase gazeuse, lors du dépôt continu de l'oxycarbonitrure de niobium.

13. Procédé selon l'une des revendications 8 à 12 pour la fabrication de faisceaux de fibres supraconducteurs selon la revendication 7, caractérisé par le fait que, dans le réacteur CVD (23), un élément augmentant la conductivité (9) est déposé à partir dr la phase gazeuse, en même temps que s'effectue le dépôt de l'oxycarbonitrure de niobium.

14. Procédé pour la fabrication de faisceaux de fibres supraconducteurs selon l'une des revendications 1 à 7, caractérisé par le fait qu'un faisceau de fibres de support est déployé en une bande de fibres de support (4I),

et qu'à cela fait suite un revêtement de tous côtés des fibres de support (40) avec de l'oxycarbonitrure de niobium, par pulvérisation cathodique, en particulier pulvérisation cathodique réactive, de niobium, en présence simultanée d'azote ou d'un composé azoté, et de carbone ou d'un composé carboné, la bande de fibres de support (41) étant éventuellement chauffée modérément, de manière que l'oxycarbonitrure de niobium se dépose en structure polycristalline.

15. Procédé selon la revendication 14, caractérisé par le fait que les fibres de support (40) sont chauffées modérément par exposition au rayonnement infrarouge, immédiatement avant ou pendant le processus de revêtement.

16. Procédé pour la fabrication d'un faisceau de fibres supraconducteur selon l'une des revendications 1 à 7, caractérisé par le fait qu'un faisceau de fibres de support (41) est déployé en une bande de fibres de support, qu'à cela fait suite, avec un ajustement approprié de la température des fibres de support (40), un revêtement de tous côtés des fibres de support (40) avec de l'oxycarbonitrure de niobium sous forme amorphe, par pulvérisation cathodique réactive, une cible en fritte d'oxycarbonitrure de niobium (59, 60) étant utilisée pour le dosage exact des composants non métalliques $O_2$, $N_2$ ou C, et que, dans un traitement thermique subséquent, le composé oxycarbonitrure de niobium amorphe est transformé en la structure B1 à grains fins.

17. Procédé selon l'une des revendications 14 à 16, caractérisé par le fait que la pulvérisation cathodique réactive est effectuée dans un champ magnétique de focalisation, lequel agit sur la densité du plasma de telle manière que les électrons du plasma sont dans une large mesure tenus à l'écart du support.

18. Procédé selon l'une des revendications 14 à 17 pour la fabrication de faisceaux de fibres supraconducteurs selon la revendication 4 ou 5, caractérisé par le fait qu'en même temps que s'effectue le revêtement des fibres de support (40) avec de l'oxycarbonitrure de niobium par pulvérisation cathodique, un matériau isolant (5, 6) est appliqué par pulvérisation cathodique sur les fibres de support (40).

19. Procédé selon l'une des revendications 14 à 17 pour la fabrication de faisceaux de fibres supraconducteurs selon la revendication 6, caractérisé par le fait que, dans un réacteur (56) pour la pulvérisation cathodique, l'oxycarbonitrure de niobium et le matériau isolant (7) sont appliqués en alternance sur les fibres de support (40).

20. Procédé selon l'une des revendications 14 à 17 pour la fabrication de faisceaux de fibres supraconducteurs selon la revendication 6, caractérisé par le fait que, lors du revêtement en continu des fibres de support (40) avec de l'oxycarbonitrure de niobium par pulvérisation cathodique, le matériau isolant (7) est appliqué par pulvérisation cathodique sur les fibres de support (40), par impulsions.

21. Procédé selon l'une des revendications 14 à 20 pour la fabrication de faisceaux de fibres supraconducteurs selon la revendication 7, caractérisé par le fait que, dans le réacteur de pulvérisation cathodique (56), un élément augmentant la conductivité (9) est appliqué par pulvérisation cathodique sur les fibres de support (40), en même temps que s'effectue le revêtement d'oxycarbonitrure de niobium.

22. Procédé selon l'une des revendications 8 à 21, caractérisé par le fait qu'après l'application de la couche supraconductrice (2) sur les fibres de support (1, 11, 40) est effectué, dans une autre étape de procédé, faisant immédiatement suite à cette application, un revêtement des fibres avec du cuivre ou de l'aluminium très pur.

23. Procédé selon l'une des revendications 8 à 22, caractérisé par le fait que le revêtement des fibres de support est effectué dans un processus continu, les fibres de support (1, 11, 40) étant déroulées d'une bobine de matière première (10, 42) et étant transportées à travers le dispositif de revêtement, et les fibres revêtues étant enroulées sur une bobine réceptrice (15, 47).

14

0 102 489

Fig. 1

Fig. 2

Fig. 3

# Fig.4

# Fig. 5

0 102 489

Fig.6